(19) Europäisches Patentamt
European Patent Office
Office européen des brevets

(11) **EP 2 915 862 A1**

(12) **EUROPEAN PATENT APPLICATION**

(43) Date of publication:
**09.09.2015 Bulletin 2015/37**

(51) Int Cl.:
***C09K 11/64*** *(2006.01)*

(21) Application number: **15154295.8**

(22) Date of filing: **09.02.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **03.03.2014 JP 2014040761**

(71) Applicant: **Kabushiki Kaisha Toshiba**
**Tokyo 105-8001 (JP)**

(72) Inventors:
• **Albessard, Keiko**
**Tokyo, 105-8001 (JP)**
• **Fukuda, Yumi**
**Tokyo, 105-8001 (JP)**

• **Ishida, Kunio**
**Tokyo, 105-8001 (JP)**
• **Mitsuishi, Iwao**
**Tokyo, 105-8001 (JP)**
• **Okada, Aoi**
**Tokyo, 105-8001 (JP)**
• **Hattori, Yasushi**
**Tokyo, 105-8001 (JP)**
• **Hiramatsu, Ryosuke**
**Tokyo, 105-8001 (JP)**
• **Kato, Masahiro**
**Tokyo, 105-8001 (JP)**

(74) Representative: **Hoffmann Eitle**
**Patent- und Rechtsanwälte PartmbB**
**Arabellastraße 30**
**81925 München (DE)**

(54) **Phosphor and producing method of phosphor and light-emitting device employing the same**

(57) The embodiment of the present disclosure provides a phosphor exhibiting an emission peak in the wavelength range of 565 to 600 nm under excitation by light having a peak in the wavelength range of 250 to 500 nm. The emission peak has a half width of 115 to 180 nm inclusive. This phosphor has a crystal structure of $Sr_2Si_7Al_3ON_{13}$, and is activated by cerium.

EP 2 915 862 A1

**Description**

FIELD

Embodiments of the present disclosure relate to a phosphor and a light-emitting device employing the same.

BACKGROUND

A white light-emitting device comprises a combination of, for example, a blue LED, a phosphor that emits red light under excitation by blue light, and another phosphor that emits green light under excitation by blue light. However, if containing a phosphor that emits yellow light under excitation by blue light, the white light-emitting device can be produced by use of fewer kinds of phosphors. Meanwhile, a warm white or incandescent color light-emitting device can be produced by use of a combination of a blue LED and a phosphor that emits orange-color light under excitation by blue light.

BRIEF DESCRIPTION OF THE DRAWINGS

Figures 1A to 1C show the crystal structure of $Sr_2Si_7Al_3ON_{13}$.
Figure 2 shows a sectional view schematically illustrating the constitution of a light-emitting device according to an embodiment.
Figure 3 shows a sectional view schematically illustrating the constitution of a light-emitting device according to another embodiment.
Figure 4 shows the XRD profiles given by the $Sr_2Si_7Al_3ON_{13}$ phosphors of Example 1 and Comparative example 2.
Figure 5 shows the emission spectra given by the phosphors of Example 1 and Comparative examples 1-a and 2.
Figure 6 shows chromaticities (x, y) calculated according to simulation based on the blue LED spectrum and the emission spectra given by the phosphors of Example 1 and Comparative example 1-b.

DETAILED DESCRIPTION

Embodiments will now be explained with reference to the accompanying drawings.
The phosphor according to the embodiment exhibits an emission spectrum with an emission peak in the wavelength range of 565 to 600 nm under excitation by light having a peak in the wavelength range of 250 to 500 nm, and the emission peak has a half width of 115 to 180 nm inclusive. This phosphor has a crystal structure of $Sr_2Si_7Al_3ON_{13}$, and is activated by cerium.
The embodiment will be explained below in detail.
Since showing luminescence with a peak wavelength of 565 to 600 nm under excitation by light with a peak wavelength of 250 to 500 nm, the phosphor according to the embodiment can emit light in orange color. This kind of phosphor thus radiates light mainly in an orange range, and hence is hereinafter referred to as an "orange-light-emitting phosphor". The orange-light-emitting phosphor of the embodiment is characterized by showing an emission spectrum with a wide half-width. Specifically, when excited by light having a peak in the wavelength range of 250 to 500 nm, the phosphor exhibits an emission peak in the wavelength range of 565 to 600 nm characteristically with a half width of 115 to 180 nm inclusive. The phosphor of the embodiment is activated by Ce, whose properties make the half-width 115 nm or more. The Ce-activated phosphor actually produced tends to show a wider emission half-width because the Ce concentration and the matrix composition are often not homogeneous throughout the phosphor. However, inhomogeneity of the Ce concentration and the matrix composition may cause deterioration of the efficiency, and hence the half-width is preferably 180 nm or less. The half-width in this range is wider than those of known Eu-activated phosphors, and accordingly the phosphor of the embodiment makes it possible to produce a light-emitting device showing a large color rendering index. In order to realize a large color rendering index, the half-width is preferably 120 nm or more but 170 nm or less.
The orange-light-emitting phosphor of the embodiment contains a matrix of essentially the same crystal structure as that of $Sr_2Si_7Al_3ON_{13}$, and the matrix is activated by Ce. Specifically, the orange-light-emitting phosphor according to the embodiment is represented by the following formula (1):

$$(Sr_{1-x}Ce_x)_{2y}Si_{10-z}Al_z(O,N)_w \qquad (1).$$

In the formula, x, y, z and w satisfy the conditions of

$$0.05 \leq x \leq 1,$$

$$1.1 < y \leq 1.4,$$

$$2 \leq z \leq 3.5,$$

and

$$13 \leq w \leq 15,$$

respectively.

If Sr is replaced with Ce in an amount of at least 0.05 mol%, the phosphor can have sufficient luminous efficiency. It is possible to completely replace Sr with Ce (that is, x may be 1), but decrease of the emission probability (concentration quenching) can be avoided to the utmost if x is less than 0.5. Accordingly, x is preferably 0.06 to 0.12 inclusive. The phosphor of the embodiment contains Ce as an emission center in a relatively large amount as compared with generally known yellow light-emitting phosphors, and thereby emits orange-color light, namely, luminescence with a broad half-width peak in the wavelength range of 565 to 600 nm under excitation by light with a peak in the wavelength range of 250 to 500 nm. There may be cases where metal elements other than Sr and Ce are contained as unavoidable impurities, but even in those cases the effect of the embodiment generally appears sufficiently.

If y is less than 1.1, crystal defects are increased to lower the efficiency. On the other hand, if y is more than 1.4, excess of the alkaline earth metal may deposit in the form of other phases to deteriorate the luminescent properties. Accordingly, y is preferably 1.15 to 1.25 inclusive.

If z is less than 2, excess Si may deposit in the form of other phases to deteriorate the luminescent properties. On the other hand, if z is more than 3.5, excess Al may deposit in the form of other phases to deteriorate the luminescent properties. Accordingly, z is preferably 2.5 to 3.3 inclusive.

In the formula, w stands for the total of O and N. If w is less than 13 or more than 15, the phosphor of the embodiment often cannot keep the crystal structure. Occasionally, other phases are formed in the production process, so that the effect of the embodiment cannot be obtained sufficiently.

Since satisfying all the above conditions, the phosphor according to the present embodiment can efficiently emit orange light with a wide half-width emission spectrum under excitation by light with a peak in the wavelength range of 250 to 500 nm. Consequently, the phosphor can provide light of excellent color rendering properties.

The orange-light-emitting phosphor according to the present embodiment is based on $Sr_2Si_7Al_3ON_{13}$, but its constituting elements Sr, Si, Al, O and N can be replaced with other elements and/or Ce to form a solid solution with the matrix. These modifications, such as replacement, often change the crystal structure. However, the atomic positions therein are only slightly changed so that the chemical bonds do not break. Here, the atomic positions depend on the crystal structure, on the sites occupied by the atoms therein and on their atomic coordinates.

The embodiment of the present disclosure leads to the aimed effect as long as the orange-light-emitting phosphor does not change its basic crystal structure. There may be a case where the crystal structure of the phosphor differs from that of $Sr_2Si_7Al_3ON_{13}$ in the lattice constants and/or in the chemical bond lengths (close interatomic distances) of Sr-N and Sr-O. However, even in that case, if the differences are within a range of $\pm 15\%$ based on the lattice constants or chemical bond lengths (Sr-N and Sr-O) in $Sr_2Si_7Al_3ON_{13}$, the crystal structure is defined to be the same. Here, the lattice constants can be determined by X-ray diffraction or neutron diffraction, and the chemical bond lengths (close interatomic distances) of Sr-N and Sr-O can be calculated from the atomic coordinates.

The $Sr_2Si_7Al_3ON_{13}$ crystal belongs to a monoclinic system, especially to an orthorhombic system with lattice constants of, for example, a=11.70 Å, b=21.41 Å and c=4.96 Å. The chemical bond lengths (Sr-N and Sr-O) in $Sr_2Si_7Al_3ON_{13}$ can be calculated from the atomic coordinates shown in Table 1.

Table 1

|  | site | occupancy | x | y | z |
|---|---|---|---|---|---|
| Sr1 | 4a | 1 | 0.2786 | 0.49060(11) | 05284(14) |
| Sr2 | 4a | 1 | 0.3552(3) | 0.69839(12) | 0.048(2) |

(continued)

|  | site | occupancy | x | y | z |
|---|---|---|---|---|---|
| Si/Al1 | 4a | 1 | 0.3582(9) | 0.2769(3) | 0.070(3) |
| Si/Al2 | 4a | 1 | 0.5782(9) | 0.7996(4) | 0.047(5) |
| Si/Al3 | 4a | 1 | 0.5563(8) | 0.4672(3) | 0.543(5) |
| Si/Al4 | 4a | 1 | 0.4724(8) | 0.6092(3) | 0.556(4) |
| Si/Al5 | 4a | 1 | 0.1910(7) | 0.6397(3) | 0.535(4) |
| Si/Al6 | 4a | 1 | 0.0061(8) | 0.5438(3) | 0.546(4) |
| Si/Al7 | 4a | 1 | 0.1625(9) | 0.5661(3) | 0.038(4) |
| Si/Al8 | 4a | 1 | 0.3937(8) | 0.3469(3) | 0.547(4) |
| Si/Al9 | 4a | 1 | 0.1552(18) | 0.3483(8) | 0.318(3) |
| Si/Al10 | 4a | 1 | 0.1525(14) | 0.3492(6) | 0.813(2) |
| O/N1 | 4a | 1 | 0.436(2) | 0.8164(10) | 0.061(11) |
| O/N2 | 4a | 1 | 0.699(2) | 0.4692(10) | 0.513(10) |
| O/N3 | 4a | 1 | 0.334(2) | 0.6355(10) | 0.511(9) |
| O/N4 | 4a | 1 | 0.213(2) | 0.2980(11) | 0.056(12) |
| 0/N5 | 4a | 1 | 0.256(2) | 0.3750(10) | 0.563(9) |
| 0/N6 | 4a | 1 | 0.894(2) | 0.6002(12) | 0.549(14) |
| O/N7 | 4a | 1 | 0.358(3) | 0.2062(12) | 0.893(6) |
| O/N8 | 4a | 1 | 0.508(2) | 0.4677(12) | 0.885(6) |
| O/N9 | 4a | 1 | 0.398(2) | 0.2727(12) | 0.392(6) |
| O/N10 | 4a | 1 | 0.430(3) | 0.3336(15) | 0.896(7) |
| O/N11 | 4a | 1 | 0.942(3) | 0.4814(15) | 0.371(8) |
| O/N12 | 4a | 1 | 0.662(2) | 0.8571(12) | 0.893(6) |
| O/N13 | 4a | 1 | 0.128(3) | 0.5743(15) | 0.381(7) |
| O/N14 | 4a | 1 | 0.495(3) | 0.3982(13) | 0.383(6) |

The orange-light-emitting phosphor according to the present embodiment needs to have the above crystal structure. If the chemical bond lengths are largely changed from the above, they can be broken to form another crystal structure and hence the effect of the present embodiment cannot be obtained.

The orange-light-emitting phosphor of the present embodiment is based on an inorganic compound having the same crystal structure as $Sr_2Si_7Al_3ON_{13}$, but the constituting element Sr is partly replaced with the emission center element Ce and the amount of each element is restricted. On those conditions, the phosphor according to the present embodiment has high luminous efficiency and shows a wide half-width emission spectrum.

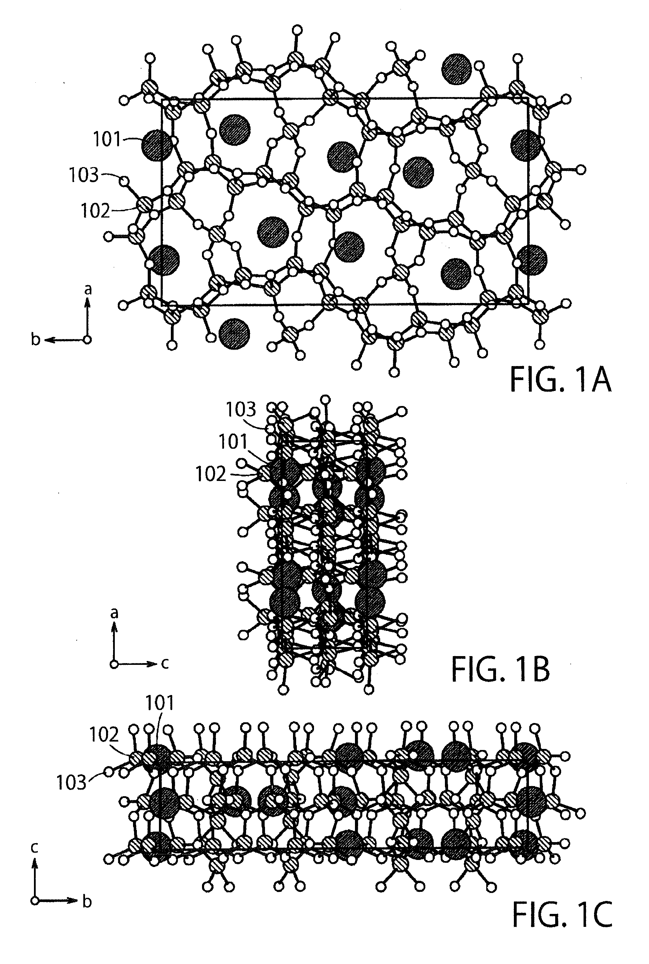

The crystal structure of $Sr_2Si_7Al_3ON_{13}$ based on the atomic coordinates in Table 1 is illustrated in Figure 1. Figures 1(a), (b) and (c) are projections of the crystal structure along the c, b and a axes, respectively. In Figures, 301 represents a Sr atom, which is surrounded by a Si or an Al atom 302 and an O or a N atom 303. The $Sr_2Si_7Al_3ON_{13}$ crystal can be identified by XRD or neutron diffraction.

The phosphor of the present embodiment has a composition represented by the above formula (1), and shows peaks at particular diffraction angles ($2\theta$s) in the X-ray diffraction profile measured with Cu-K$\alpha$ line radiation according to Bragg-Brendano method. This means that its XRD profile has at least ten peaks at the diffraction angles ($2\theta$s) of 11.06 to 11.46°, 18.24 to 18.64°, 19.79 to 20.18°, 23.02 to 23.42°, 24.80 to 25.20°, 25.60 to 26.00°, 25.90 to 26.30°, 29.16 to 29.56°, 30.84 to 31.24°, 31.48 to 31.88°, 32.92 to 33.32°, 33.58 to 33.98°, 34.34 to 34.74°, 35.05 to 35.45°, 36.06 to 36.46°, 36.46 to 36.86°, 37.15 to 37.55°, 48.28 to 48.68°, and 56.62 to 57.02°.

The orange-light-emitting phosphor according to the present embodiment can be produced by the steps of mixing the raw materials containing the above elements and then firing the mixture.

The material containing Sr can be selected from a silicide, nitride or a carbide of Sr; the material containing Al can be selected from a nitride, an oxide or a carbide of Al; the material containing Si can be selected from a nitride, an oxide or a carbide of Si; and the material containing the emission center Ce can be selected from an oxide, a nitride or a carbonate of Ce.

In addition, nitrogen can be supplied from the above nitrides or from a nitrogen-containing firing atmosphere, and oxygen can be supplied from the above oxides or from the oxidized surface of the above nitrides particles.

For example, $Sr_3N_2$, AlN, $Si_3N_4$, $Al_2O_3$ and AlN, and $CeO_2$ are mixed in appropriate amounts to give the aimed composition. $Sr_3N_2$ may be replaced with $Sr_2N$, SrN or its mixture. For the purpose of obtaining a homogeneous powder mixture, the raw materials in powder form are preferably dry-mixed in the order of smaller to larger weights.

The materials are mixed, for example, in a mortar placed in a glove box. The mixed powder is placed in a crucible and then fired on particular conditions to obtain the phosphor of the embodiment. There are no particular restrictions in the materials of the crucible, which is made of, for example, boron nitride, silicon nitride, silicon carbide, carbon, aluminum nitride, SiAlON, aluminum oxide, molybdenum or tungsten.

The mixed powder is preferably fired under a pressure not less than the atmospheric pressure. Since the silicon nitride decomposes easily, it is advantageous to fire the mixture under a pressure not less than the atmospheric pressure. In order to prevent the silicon nitride from decomposition at a high temperature, the pressure is preferably 5 atm or more and the firing temperature is preferably in the range of 1500 to 2000°C. If those conditions are satisfied, the aimed fired product can be obtained without suffering from troubles such as sublimation of the raw materials and/or of the product. The firing temperature is more preferably in the range of 1800 to 2000°C.

For the purpose of avoiding oxidation of AlN, the firing step is preferably carried out in a nitrogen atmosphere.

After the firing step is carried out at the above temperature for 0.5 to 4 hours, the fired product is taken out of the crucible and then ground. The ground product is preferably fired again under the same conditions. If those firing and grinding procedures are repeated from 1 to 10 times, the product has the advantages that the crystal grains are less fused, and further, the composition and the crystal structure of the formed powder are more uniform.

After the firing step, the product is subjected to after-treatment such as washing, if necessary, to obtain a phosphor according to the embodiment. The washing can be carried out, for example, by using pure water or acid. Examples of the acid include: inorganic acids, such as sulfuric acid, nitric acid, hydrochloric acid and hydrofluoric acid; organic acids, such as formic acid, acetic acid and oxalic acid; and mixtures thereof.

After washed with acid, the product may be subjected to post-annealing treatment, if necessary. The post-annealing treatment, which can be carried out, for example, in a reductive atmosphere containing nitrogen and hydrogen, improves the crystallinity and the luminous efficiency.

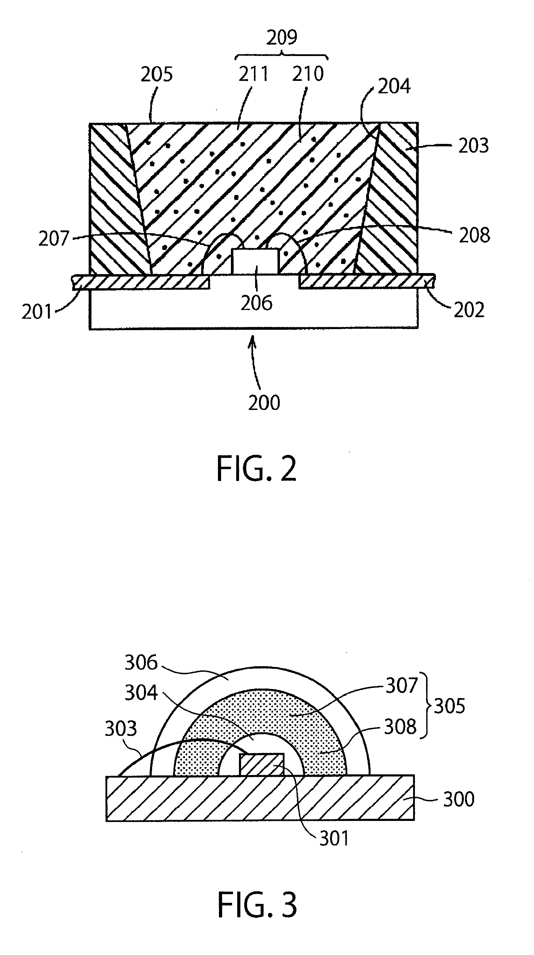

The light-emitting device according to the embodiment comprises a luminescent layer containing the above phosphor and a light-emitting element capable of exciting the phosphor. Figure 2 shows a vertical sectional view schematically illustrating a light-emitting device according to an embodiment of the present disclosure.

The light-emitting device shown in Figure 2 comprises leads 201, 202 and a package cup 203 on a substrate 200. The package cup 203 and the substrate 200 are made of resin. The package cup 203 has a concavity 205 in which the top opening is larger than the bottom. The inside wall of the concavity 205 functions as a reflective surface 204.

At the center of the nearly circular bottom of the concavity 205, there is a light-emitting element 206 mounted with Ag paste or the like. The light-emitting element 206 radiates light with a peak in the wavelength range of 250 to 500 nm, preferably 400 to 500 nm, more preferably 380 to 500 nm. Examples of the light-emitting element 206 include light-emitting diodes and laser diodes, such as GaN type semiconductor light-emitting chips, but they by no means restrict the light-emitting element.

The p- and n-electrodes (not shown) of the light-emitting element 206 are connected to the leads 201 and 202 by way of bonding wires 207 and 208 made of Au or the like, respectively. The positions of the leads 201 and 202 can be adequately modified.

The light-emitting element 206 may be of a flip chip type in which the n- and p-electrodes are placed on the same plane. This element can avoid troubles concerning the wires, such as disconnection or dislocation of the wires and light-absorption by the wires. In that case, therefore, it is possible to obtain a semiconductor light-emitting device excellent both in reliability and in luminance. Further, it is also possible to adopt a light-emitting element having an n-type substrate so as to produce a light-emitting device constituted as described below. In that device, an n-electrode is formed on the back surface of the n-type substrate while a p-electrode is formed on the top surface of a p-type semiconductor layer beforehand laid on the substrate. The n-electrode is mounted on one of the leads, and the p-electrode is connected to the other lead by way of a wire.

In the concavity 205 of the package cup 203, there is a luminescent layer 209 containing the phosphor 210 according to an embodiment of the present disclosure. In the luminescent layer 209, the phosphor 210 is contained in a resin layer 211 made of, for example, silicone resin in an amount of 5 to 60 wt%. As described above, the phosphor according to the embodiment comprises $Sr_2Al_3Si_7ON_{13}$ matrix. Since that kind of oxynitride has high covalency, the phosphor of the embodiment is generally so hydrophobic that it has good compatibility with the resin. Accordingly, scattering at the interface between the resin and the phosphor is prevented enough to improve the light-extraction efficiency.

The orange-light-emitting phosphor according to the embodiment can efficiently emit orange light with a wide half-width emission spectrum. This phosphor is used in combination with a light-emitting element radiating light with a peak in the wavelength range of, for example, 400 to 500 nm, and thereby it becomes possible to provide a light-emitting device excellent in luminescent properties.

The size and kind of the light-emitting element 206 and the dimension and shape of the concavity 205 can be properly changed.

The light-emitting device according to an embodiment of the present disclosure is not restricted to the package cup-type shown in Figure 2, and can be freely applied to any type of devices. For example, even if the phosphor of the embodiment is used in a shell-type or surface-mount type LED, the same effect can be obtained.

Figure 3 shows a vertical sectional view schematically illustrating a light-emitting device according to another embodiment of the present disclosure. In the shown device, p- and n-electrodes (not shown) are formed at the predetermined positions on a heat-releasing insulating substrate 300, and a light-emitting element 301 is placed thereon. The heat- releasing insulating substrate is made of, for example, AIN.

On the bottom of the light-emitting element 301, one of the electrodes of the element is provided and electrically connected to the n-electrode of the heat-releasing insulating substrate 300. The other electrode of the light-emitting element 301 is connected to the p-electrode (not shown) on the heat-releasing insulating substrate 300 by way of a gold wire 303. The light-emitting element 301 is a light-emitting diode radiating light with a peak in the wavelength range of 400 to 500 nm.

The light-emitting element 301 is successively domed with an inner transparent resin layer 304, a luminescent layer 305 and an outer transparent resin layer 306 in this order. The inner and outer transparent resin layers 304 and 306 are made of, for example, silicone resin. In the luminescent layer 305, the orange-light-emitting phosphor 307 according to the embodiment is dispersed in a resin layer 308 made of, for example, silicone resin.

In the production process of the light-emitting device shown in Figure 3, the luminescent layer 305, which contains the orange-light-emitting phosphor of the embodiment, can be easily formed by use of techniques such as vacuum printing and drop-coating from a dispenser. Further, since positioned between the inner and outer transparent resin layers 304 and 306, the luminescent layer 305 also has the function of improving the extraction efficiency.

In forming the luminescent layer of the light-emitting device according to the embodiment, particles of the phosphor may be one-by-one directly placed on the light-emitting element in a number needed to realize the aimed emission color. This is particularly effective if the luminescent layer is to be formed by use of a phosphor like the orange-light-emitting phosphor of the embodiment, which is often obtained as a portion of phosphor powder experimentally produced in the manner described later in Example.

The luminescent layer in the light-emitting device of the embodiment may contain not only the orange-light-emitting phosphor of the embodiment but also another phosphor emitting green luminescence under excitation by blue light and still another phosphor emitting red luminescence under excitation by blue light. If comprising that luminescent layer, the produced light-emitting device is further improved in color rendering properties.

Even when excited by UV light with a peak in the wavelength range of 250 to 400 nm, the orange-light-emitting phosphor of the embodiment radiates orange-color luminescence. Accordingly, the phosphor of the embodiment can be combined with, for example, another phosphor emitting blue light under excitation by UV light and a light-emitting element such as a UV light-emitting diode, to produce a light-emitting device. In that light-emitting device, the luminescent layer may contain not only the orange-light-emitting phosphor of the embodiment but also a phosphor emitting luminescence with a peak in another wavelength range under excitation by UV light. That phosphor is, for example, a phosphor emitting red light under excitation by UV light or a phosphor emitting green light under excitation by UV light.

As described above, the phosphor according to the embodiment can efficiently emit orange light with an emission spectrum having a wide half-width. That orange-light-emitting phosphor of the embodiment can be combined with a light-emitting element radiating light with a peak in the wavelength range of 250 to 500 nm, and thereby it becomes possible to produce a light-emitting device excellent in luminescent properties by use of fewer kinds of phosphors.

The light-emitting device according to the embodiment comprises the above particular orange-light-emitting phosphor in the luminescent layer, and thereby has excellent color rendering properties. That is because the phosphor exhibits an emission spectrum having an emission peak in the wavelength range of 565 to 600 nm with a half width of 115 to 180 nm inclusive. Specifically, the light-emitting device of the embodiment shows an average color rendering index (Ra) of generally 60 or more, preferably 65 or more. In contrast, conventional light-emitting devices comprising known Eu-activated phosphors generally show average color rendering indexes of 55 or less, and hence it is difficult for them to achieve color rendering indexes of 60 or more.

The following are concrete examples of the phosphor and the light-emitting device.

Examples

As the raw materials containing Sr, Ce, Si and Al, $Sr_3N_2$, $CeO_2$, $Si_3N_4$ and AlN were prepared and weighed out in the blending amounts of 2.851 g, 0.103 g, 5.261 g and 1.332 g, respectively, in a glove box. The materials were then dry-mixed in an agate mortar.

The obtained mixture was laid in a crucible made of boron nitride (BN) and then fired at 1800°C for 2 hours under 7.5 atm in a nitrogen atmosphere. The fired product was taken out of the crucible, and then ground in an agate mortar. The ground product was laid again in the crucible, and fired at 1800°C for 2 hours. Those procedures of taking out, grinding and firing were further repeated twice, to obtain a phosphor. The obtained phosphor was in the form of yellow powder, and was observed to partly emit orange-color luminescence when excited by black light.

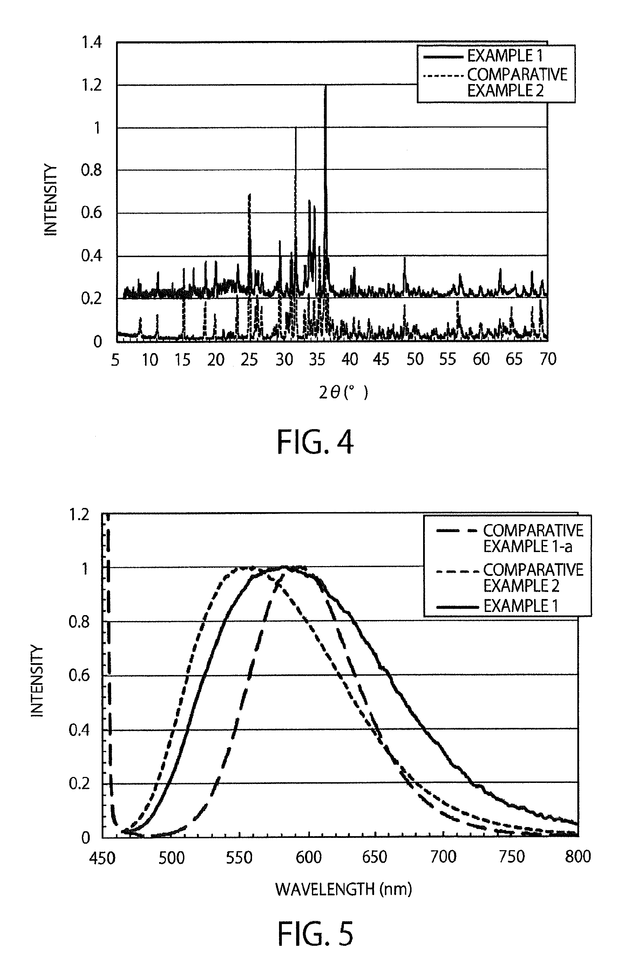

The portion emitting orange luminescence was collected to obtain the phosphor of Example 1. Figure 5 shows an emission spectrum given by the phosphor of Example 1 under excitation by light of a xenon lamp at 450 nm. In Figure 5, the narrow band at about 450 nm is attributed not to the luminescence of the phosphor but to reflection of the excitation light. The emission spectrum shows an intense band with a peak at 581 nm, and the half-width thereof was measured and found to be 153 nm by means of a multi-channel spectrophotometer. The half-width can be regarded as an index for color rendering properties of light radiated from the light-emitting device. Generally, the larger the half-width is, the more easily light having excellent color rendering properties can be obtained. Since showing luminescence with a wide half-width, the phosphor of the embodiment was found to readily provide light having excellent color rendering properties.

Meanwhile, a commercially available phosphor (Ca-activated $\alpha$-SiAlON phosphor) was adopted as the phosphor of Comparative example 1-a, and its emission spectrum was measured in the same manner. As a result, the emission peak wavelength and the half-width thereof were found to be 593 nm and 90 nm, respectively.

Subsequently, the emission spectrum given by the phosphor of Example 1 was used to simulate a light-emitting device exhibiting an incandescent color spectrum. The simulation was carried out on the assumption that the phosphor is combined with a blue LED showing an emission spectrum with a peak in the wavelength range of 400 to 470 nm, and thereby the color temperature, chromaticity and Ra were calculated.

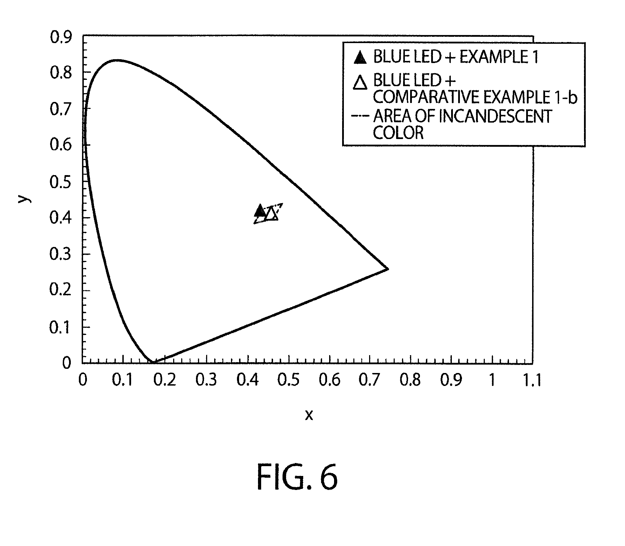

As a result, according to the simulation based on the spectrum given by the phosphor of Example 1, the color temperature, chromaticity and Ra were estimated to be 3259K, (0.430, 0.421) and Ra=70, respectively. On the other hand, according to the simulation based on the spectrum given by the phosphor of Comparative example 1-b, which was a Ca-activated $\alpha$-SiAlON phosphor similar to that of Comparative example 1-a, the color temperature, chromaticity and Ra were estimated to be 2843K, (0.457, 0.424) and Ra=52, respectively. Figure 6 shows each chromaticity obtained by the calculation, and Table 2 shows the calculation results.

Table 2

|  | Comparative example 1-b | Example 1 |
|---|---|---|
| Color temperature | 2843K | 3259K |
| Chromaticity (x, y) | (0.457, 0.424) | (0.430, 0.421) |
| Color rendering index Ra | 52 | 70 |

Thus, the phosphor according to the embodiment was combined with a blue LED showing an emission peak wavelength of 400 to 470 nm, to obtain a light-emitting device according to the embodiment. The obtained device was found to be characteristically excellent both in luminous efficiency and in color rendering properties.

The phosphor of Example 1 was subjected to micro-focus X-ray diffraction ($\mu$XRD) measurement by means of an X-ray diffractometer for thin films (D8 Discover Gadds with Vantec-2000 [trademark], manufactured by Bruker AXS). The result is shown by the solid line in Figure 4. The XRD profiles in Figure 4 were obtained by X-ray diffraction measurement with Cu-K$\alpha$ line radiation according to Bragg-Brendano method. As shown in Figure 4, there were peaks at the diffraction angles ($2\theta$s) of 11.06 to 11.46°, 18.24 to 18.64°, 19.79 to 20.18°, 23.02 to 23.42°, 24.80 to 25.20°, 25.60 to 26.00°, 25.90 to 26.30°, 29.16 to 29.56°, 30.84 to 31.24°, 31.48 to 31.88°, 32.92 to 33.32°, 33.58 to 33.98°, 34.34 to 34.74°, 35.05 to 35.45°, 36.06 to 36.46°, 36.46 to 36.86°, 37.15 to 37.55°, 48.28 to 48.68°, and 56.62 to 57.02°.

The broken line in Figure 4 shows an XRD profile (XRD powder pattern) given by a Ce-activated yellow light-emitting phosphor (Comparative example 2) having a $Sr_2Si_7Al_3ON_{13}$ crystal structure.

Table 3 shows relative intensities of the peaks in Figure 4.

EP 2 915 862 A1

Table 3

| $2\theta(°)$ | Comparative example 2 | Example 1 |
|---|---|---|
| 11.06~11.46 | 11.11 | 11.26 |
| 18.24~18.64 | 18.33 | 18.44 |
| 19.79~20.18 | 19.84 | 19.98 |
| 23.02~23.42 | 23.08 | 23.22 |
| 24.80~25.20 | 24.91 | 25.00 |
| 25.60~26.00 | 25.74 | 25.80 |
| 25.90~26.30 | 26.03 | 26.10 |
| 29.16~29.56 | 29.35 | 29.36 |
| 30.84~31.24 | 31.00 | 31.04 |
| 31.48~31.88 | 31.69 | 31.68 |
| 32.92~33.32 | 33.02 | 33.12 |
| 33.58~33.98 | 33.64 | 33.78 |
| 34.34~34.74 | 34.46 | 34.54 |
| 35.05~35.45 | 35.32 | - |
| 36.06~36.46 | 36.12 | 36.26 |
| 36.46~36.86 | 36.59 | 36.66 |
| 37.15~37.55 | 37.35 | - |
| 48.28~48.68 | 48.39 | 48.48 |
| 56.62~57.02 | 56.80 | 56.82 |

The lattice constants were calculated from the XRD profiles, and, as a result, those of Comparative example 2 and Example 1 were found to be a=11.69 Å, b=21.38 Å, c=4.96 Å and a=11.69 Å, b=21.34 Å, c=4.95 Å, respectively.

Further, three particles were picked up from the phosphor of Example 1 and subjected to composition analysis by means of an electron probe microanalyser (EPMA, JXA-8100 [trademark], manufactured by JEOL Ltd.). For comparison, the Ce-activated yellow light-emitting phosphor (Comparative example 2) having a $Sr_2Si_7Al_3ON_{13}$ crystal structure was also subjected to composition analysis in the same manner. The results are shown in Table 4.

Table 4

| | Composition | | | | |
|---|---|---|---|---|---|
| | Sr | Ce | Sr+Ce | Si | Al |
| | 1-x | x | 2y | 10-z | Z |
| Example 1-1 | 0.92 | 0.08 | 2.3 | 7.4 | 2.6 |
| Example 1-2 | 0.94 | 0.06 | 2.3 | 7.4 | 2.6 |
| Example 1-3 | 0.88 | 0.12 | 2.5 | 7.4 | 2.6 |
| Comparative example 2 | 0.96 | 0.04 | 2.1 | 7.6 | 2.4 |

The embodiment of the present disclosure provides a phosphor capable of highly efficiently emitting orange-color light with a wide half-width emission spectrum. If the orange-light-emitting phosphor of the embodiment is combined with a blue LED, it becomes possible to obtain a light-emitting device excellent in both color rendering properties and luminescent properties.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

**Claims**

1. A phosphor, which exhibits an emission spectrum with an emission peak in the wavelength range of 565 to 600 nm under excitation by light having a peak in the wavelength range of 250 to 500 nm provided that said emission peak has a half-width of 115 to 180 nm inclusive, and said phosphor has a crystal structure of $Sr_2Si_7Al_3ON_{13}$, and is activated by cerium.

2. The phosphor according to claim 1, represented by the following formula (1):

$$(Sr_{1-x}Ce_x)_{2y}Si_{10-z}Al_z(O,N)_w \qquad (1)$$

in which x, y, z and w satisfy the conditions of

$$0.06 \leq x \leq 1,$$

$$1.1 < y \leq 1.25,$$

$$2 \leq z \leq 3.5,$$

and

$$13 \leq w \leq 15,$$

respectively.

3. The phosphor according to claim 1, wherein said crystal structure has lattice constants the differences of which from those in $Sr_2Si_7Al_3ON_{13}$ are within a range of $\pm 15\%$.

4. The phosphor according to claim 1, wherein said crystal structure has chemical bond lengths of Sr-N and Sr-O the differences of which from those in $Sr_2Si_7Al_3ON_{13}$ are within a range of $\pm 15\%$.

5. The phosphor according to claim 1, showing at least ten peaks at the diffraction angles (2θs) of 11.06 to 11.46°, 18.24 to 18.64°, 19.79 to 20.18°, 23.02 to 23.42°, 24.80 to 25.20°, 25.60 to 26.00°, 25.90 to 26.30°, 29.16 to 29.56°, 30.84 to 31.24°, 31.48 to 31.88°, 32.92 to 33.32°, 33.58 to 33.98°, 34.34 to 34.74°, 35.05 to 35.45°, 36.06 to 36.46°, 36.46 to 36.86°, 37.15 to 37.55°, 48.28 to 48.68°, and 56.62 to 57.02°, in X-ray diffraction measurement according to Bragg-Brendano method with Cu-Kα line radiation.

6. The phosphor according to claim 1, produced by the steps of

mixing
a material containing Sr selected from a silicide nitride or a carbide of Sr,
a material containing Al selected from a nitride, an oxide or a carbide of Al,
a material containing Si selected from a nitride, an oxide or a carbide of Si, and
a material containing Ce selected from an oxide, a nitride or a carbonate of Ce,

to prepare a mixture; and then

firing the mixture.

7. The phosphor according to claim 6, wherein said mixture of materials is fired in a nitrogen gas atmosphere under increased pressure from 1 to 10 times and then further fired in a nitrogen and hydrogen atmosphere under atmospheric pressure.

8. A light-emitting device comprising
   a light-emitting element radiating light with a peak in the wavelength range of 250 to 500 nm, and
   a luminescent layer containing the phosphor according to claim 1.

9. The device according to claim 8, showing an average color rendering index (Ra) of 60 or more.

10. A method for producing the phosphor according to claim 1, comprising the steps of

    mixing
    a material containing Sr selected from a silicide, nitride or a carbide of Sr,
    a material containing Al selected from a nitride, an oxide or a carbide of Al,
    a material containing Si selected from a nitride, an oxide or a carbide of Si, and
    a material containing Ce selected from an oxide, a nitride or a carbonate of Ce,

    to prepare a mixture; and then

    firing the mixture.

11. The method according to claim 10, wherein said mixture is prepared by dry-mixing the materials in powder form in the order of smaller to larger weights.

12. The method according to claim 10, wherein said step of firing is carried out according to single-stage firing at a temperature of 1500 to 2000°C under 5 atm or more.

13. The method according to claim 12, wherein said step of firing is carried out in a nitrogen atmosphere.

14. The method according to claim 13, wherein, after said of firing, the fired mixture being fired in a nitrogen and hydrogen atmosphere.

FIG. 1A

FIG. 1B

FIG. 1C

FIG. 2

FIG. 3

FIG. 4

FIG. 5

FIG. 6

Europäisches
Patentamt

European
Patent Office

Office européen
des brevets

# EUROPEAN SEARCH REPORT

Application Number

EP 15 15 4295

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 597 129 A1 (TOSHIBA KK [JP]) 29 May 2013 (2013-05-29) * paragraphs [0017], [0047], [0051]; claims 1-15 * | 1-14 | INV. C09K11/64 |
| X | US 2006/197439 A1 (SAKANE KENJI [JP] ET AL) 7 September 2006 (2006-09-07) * claims 1-23; example 37; table 6 * | 1-14 | |
| X | US 2007/228949 A1 (MARUYAMA TSUKASA [JP] ET AL) 4 October 2007 (2007-10-04) * paragraphs [0065] - [0081]; example 1 * | 1-14 | |
| X | US 2007/075629 A1 (LE TOQUIN RONAN P [US] ET AL) 5 April 2007 (2007-04-05) * paragraphs [0040] - [0073]; claims 1-36 * | 1-14 | |
| A | US 2006/244356 A1 (NAGATOMI AKIRA [JP] ET AL) 2 November 2006 (2006-11-02) * paragraph [0117]; claims 1-22; examples 5, 11 * | 1-14 | TECHNICAL FIELDS SEARCHED (IPC) C09K |

The present search report has been drawn up for all claims

| Place of search | Date of completion of the search | Examiner |
|---|---|---|
| The Hague | 28 April 2015 | Kövecs, Monika |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 15 15 4295

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2015

| Patent document cited in search report | | Publication date | Patent family member(s) | | Publication date |
|---|---|---|---|---|---|
| EP 2597129 | A1 | 29-05-2013 | CN | 103113895 A | 22-05-2013 |
| | | | EP | 2597129 A1 | 29-05-2013 |
| | | | JP | 2013104041 A | 30-05-2013 |
| | | | KR | 20130054123 A | 24-05-2013 |
| | | | KR | 20140130078 A | 07-11-2014 |
| | | | TW | 201335336 A | 01-09-2013 |
| | | | US | 2013241387 A1 | 19-09-2013 |
| US 2006197439 | A1 | 07-09-2006 | NONE | | |
| US 2007228949 | A1 | 04-10-2007 | US | 2007228949 A1 | 04-10-2007 |
| | | | US | 2010013375 A1 | 21-01-2010 |
| US 2007075629 | A1 | 05-04-2007 | EP | 1929501 A2 | 11-06-2008 |
| | | | EP | 1929502 A2 | 11-06-2008 |
| | | | EP | 2236580 A2 | 06-10-2010 |
| | | | JP | 2009510230 A | 12-03-2009 |
| | | | JP | 2009512741 A | 26-03-2009 |
| | | | KR | 20080059418 A | 27-06-2008 |
| | | | KR | 20080059419 A | 27-06-2008 |
| | | | US | 2007075629 A1 | 05-04-2007 |
| | | | US | 2007159066 A1 | 12-07-2007 |
| | | | WO | 2007041402 A2 | 12-04-2007 |
| | | | WO | 2007041563 A2 | 12-04-2007 |
| US 2006244356 | A1 | 02-11-2006 | JP | 4975269 B2 | 11-07-2012 |
| | | | JP | 2006307090 A | 09-11-2006 |
| | | | US | 2006244356 A1 | 02-11-2006 |

EPO FORM P0459

For more details about this annex : see Official Journal of the European Patent Office, No. 12/82